# EUROPEAN PATENT APPLICATION

(11) **EP 4 525 562 A1**
(43) Date of publication of application: **19.03.2025**
(21) Application number: 23840018.8
(22) Date of filing: 14.07.2023
(51) Int. Cl.: H05K 1/02, H05K 1/11, H05K 3/28, H01L 23/12, H01L 23/00, H01L 23/498, H01L 23/31

(54) **CIRCUIT BOARD, CIRCUIT BOARD ASSEMBLY, AND DEVICE COMPRISING SAME**

(30) Priority: 14.07.2022 KR 20220087177; 11.07.2023 KR 20230089764
(71) Applicant: LG Energy Solution, Ltd., Seoul 07335 (KR)
(72) Inventor: YEON, Je Dong, Daejeon 34122 (KR)
(74) Representative: Plasseraud IP
(86) International application number: PCT/KR2023/010135
(87) International publication number: WO 2024/014927

(57) **Abstract**

The present invention relates to a circuit board, a circuit board assembly, and a device including the same. The circuit board assembly may include a circuit board comprising a first outer surface and a second outer surface, which face each other, and a semiconductor package disposed on the first outer surface of the circuit board, wherein the circuit board may include at least one opening disposed adjacent to at least a portion of an edge of the semiconductor package and provided in the form of a groove or hole, and a filling member filled into the at least one opening.

## Description

### TECHNICAL FIELD

### CROSS-REFERENCE TO RELATED APPLICATION

The present application claims the benefit of the priority of Korean Patent Application Nos. 10-2022-0087177, on July 14, 2022, and filed 10-2023-0089764, filed on July 11, 2023, which are hereby incorporated by reference in their entirety.

### TECHNICAL FIELD

The present invention relates to a circuit board, a circuit board assembly, and a device including the same, and more specifically, to a circuit board capable of improving vibration durability, a circuit board assembly, and a device including the same.

### BACKGROUND ART

Recently, as demands for portable electronic products such as laptops, video cameras, and mobile phones have rapidly increased, and development of electric vehicles, energy storage batteries, robots, satellites, etc. is regularized, a lot of researches have been conducted on a secondary battery used as a driving power source.

A secondary battery may transmit a signal through a circuit board on which various electronic components are mounted. A conductive pad formed on the circuit board may be electrically connected to a chip-shaped electronic component through a plurality of connection terminals. When external vibration is transmitted to such a circuit board, fatigue may be accumulated at a portion at which the connection terminal and the conductive pad are in contact with each other. Damage due to the fatigue accumulation may easily occur at the portion at which the connection terminal and the conductive pad are in contact with each other to deteriorate durability against fatigue destruction.

### DISCLOSURE OF THE INVENTION

### TECHNICAL PROBLEM

An embodiment of the present invention is to provide a circuit board capable of improving vibration durability, a circuit board assembly, and a device including the same.

The object of the present invention is not limited to the aforesaid, but other objects not described herein will be clearly understood by those skilled in the art from descriptions below.

### TECHNICAL SOLUTION

A circuit board assembly according to an embodiment of the present invention may include: a circuit board comprising a first outer surface and a second outer surface, which face each other; and a semiconductor package disposed on the first outer surface of the circuit board, wherein the circuit board may include: at least one opening disposed adjacent to at least a portion of an edge of the semiconductor package and provided in the form of a groove or hole; and a filling member filled into the at least one opening.

According to an embodiment, the at least one opening may be provided in the form of a hole passing through the first outer surface and the second outer surface.

According to an embodiment, the at least one opening may be configured to pass through at least a portion of at least one of a plurality of insulating layers provided in the circuit board.

According to an embodiment, a thermal expansion coefficient of the filling member may be the same as a thermal expansion coefficient of at least one of the plurality of insulating layers.

According to an embodiment, the filling member may be made of an insulating resin.

According to an embodiment, the circuit board assembly may further include: a plurality of connection terminals configured to electrically connect the semiconductor package to the circuit board, and each of which is provided in the form of a ball; a plurality of conductive pads connected to the plurality of connection terminals, wherein the opening may be disposed adjacent to at least one connection terminal disposed at the outermost side of the plurality of connection terminals.

According to an embodiment, the circuit board assembly may further include a signal line provided as at least one of a plurality of conductive layers provided in the circuit board, wherein the signal line may be disposed between the openings or disposed to bypass the openings.

According to an embodiment, the circuit board assembly may further include: a plurality of conductive layers disposed between the plurality of insulating layers; a via hole passing through at least one of the plurality of insulating layers; and a conductive via provided in the via hole to connect the adjacent conductive layers to each other, wherein a depth of the opening may be deeper than a depth of the via hole.

According to an embodiment, the circuit board assembly may further include an encapsulation member configured to cover a portion of the circuit board and the semiconductor package and being in contact with the filling member.

According to an embodiment, the encapsulation member may be in contact with the filling member within the opening.

According to an embodiment, the circuit board assembly may further include an encapsulation member configured to cover a portion of the circuit board and the semiconductor package and made of the same material as the filling member.

According to an embodiment, the encapsulation member may be integrated with the filling member.

According to an embodiment of the present invention, a circuit board including a first outer surface that is a surface, on which a semiconductor package is disposed, and a second outer surface facing the first outer surface may include: at least one opening disposed adjacent to at least a portion of an edge of the semiconductor package and provided in the form of a groove or hole; and a filling member filled into the at least one opening.

A battery device according to an embodiment of the present invention may include: at least one battery pack each of which comprises a plurality of battery cells; a battery management system (BMS) configured to manage the plurality of battery cells and provided as a semiconductor package; and the above-described circuit board on which the battery management system is mounted.

### ADVANTAGEOUS EFFECTS

According to the embodiment of the present invention, the filling member filled into the opening passing through at least the portion of the circuit board may be provided. Therefore, the present invention may attenuate the vibration transmitted from the filling member to the connection terminal to improve the vibration durability.

In addition, according to the embodiment of the present invention, the circuit board due to the environmental vibration input from the outside may be prevented from being damaged, and the fatigue failure of the bonding part between the conductive pad and the connection terminal may be delayed to improve the reliability.

In addition, the various effects that are directly or indirectly identified through the present disclosure may be provided.

### BRIEF DESCRIPTION OF THE DRAWINGS

FIG. 1 is a plan view illustrating a circuit board assembly according a first embodiment of the present invention.
FIG. 2 is a cross-sectional view taken along line "A-A'" in the circuit board assembly illustrated in FIG. 1.
FIG. 3 is a cross-sectional view for explaining a vibration attenuation process of a circuit board assembly according to an embodiment of the present invention.
FIG. 4 is an enlarged plane view of a region B of FIG. 1.
FIG. 5 is a cross-sectional view illustrating a filling member that is in contact with an encapsulation member of a circuit board assembly according to a second embodiment of the present invention.
FIG. 6 is a cross-sectional view illustrating the filling member that is integrated with the encapsulation member of the circuit board assembly according to the second embodiment of the present invention.

### MODE FOR CARRYING OUT THE INVENTION

Hereinafter, preferred embodiments of the present invention will be described in detail with reference to the accompanying drawings so that those of ordinary skill in the art can easily carry out the present invention. However, the present invention may be implemented in several different forms and is not limited or restricted by the following embodiments.

In order to clearly explain the present invention, detailed descriptions of portions that are irrelevant to the description or related known technologies that may unnecessarily obscure the gist of the present invention have been omitted, and in the present specification, reference symbols are added to components in each drawing. In this case, the same or similar reference numerals are assigned to the same or similar elements throughout the specification.

Also, terms or words used in this specification and claims should not be restrictively interpreted as ordinary meanings or dictionary-based meanings, but should be interpreted as meanings and concepts conforming to the scope of the present invention on the basis of the principle that an inventor can properly define the concept of a term to describe and explain his or her invention in the best ways.

### Circuit board assembly according to first embodiment

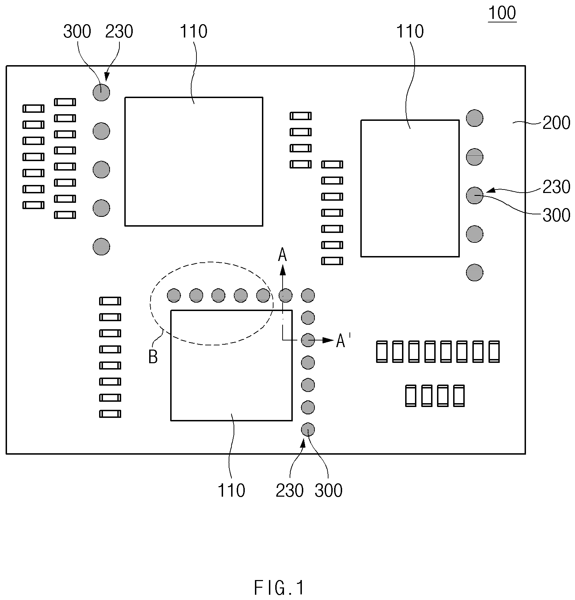

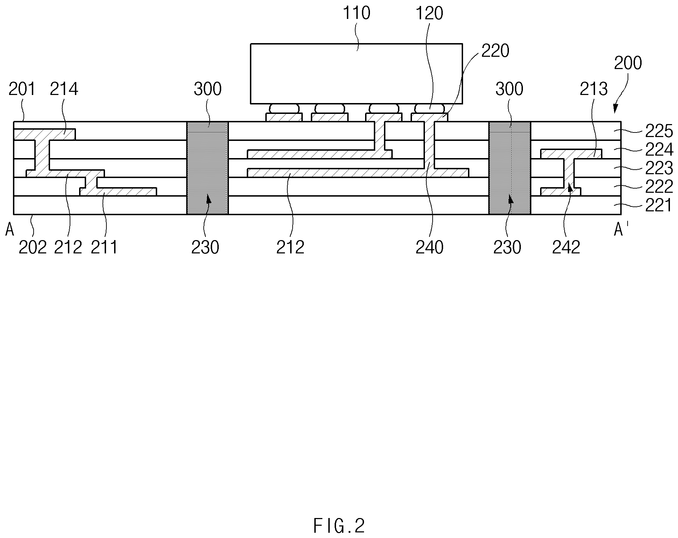

FIG. 1 is a plan view illustrating a circuit board assembly according a first embodiment of the present invention, and FIG. 2 is a cross-sectional view taken along line "A-A'" in the circuit board assembly illustrated in FIG. 1.

Referring to FIGS. 1 and 2, a circuit board assembly 100 according to an embodiment of the present invention may include a circuit board 200 and a semiconductor package 110 mounted on the circuit board 200.

The semiconductor package 110 may be disposed on the circuit board 200 and may be electrically connected to the circuit board 200 through a connection terminal 120. The semiconductor package 110 may include at least one of an active element or a passive element. The active element may include a transistor or an integrated circuit (IC). The passive element may include at least one of a condenser, a resistor, or an inductor. For example, the semiconductor package 110 may include at least one semiconductor chip, and the passive element may improve a signal processing speed of the semiconductor chip or perform a filtering function.

The semiconductor package 110 may include a plurality of connection terminals 120 disposed on a surface thereof facing the circuit board 200. The connection terminals 120 may include solder balls or solder pads. According to types of the connection terminals 120, the semiconductor package 110 may have the form of a ball grid array (BGA), a fine ball-grid array (FBGA), or a land grid array (LGA).

The connection terminal 120 may be disposed between the semiconductor package 110 and the circuit board 200 and may be provided in at least one or more.

The circuit board 200 may include a first outer surface 201 facing the semiconductor package 110 and a second outer surface 202 directed in a direction opposite to the first outer surface 201. At least one semiconductor package 110 may be mounted on the first outer surface 201 of the circuit board 200. The first outer surface 201 of the circuit board 200 may be a top surface of an insulating layer 225 disposed at the uppermost side of the plurality of insulating layers 221, 222, 223, 224, and 225 or may be a top surface of a solder resist layer (not shown). The solder resist layer may be disposed on a region other than the region on which the connection terminals 120 are disposed. The solder resist layer may be disposed around at least one of the conductive pads 220. The solder resist layer may serve to prevent short circuit of the conductive pads 220 disposed on the circuit board 200 and protect the conductive pads 220 from an external impact, moisture, or contaminants. The second outer surface 202 of the circuit board 200 may be a bottom surface of the insulating layer 221 disposed at the lowermost side of the plurality of insulating layers 221, 222, 223, 224, and 225.

The circuit board 200 may include a plurality of insulating layers 221, 222, 223, 224, and 225, a plurality of conductive layers 211, 212, 213, and 214, at least one conductive pad 220, at least one opening 230, and a filling member 300 (or damping member).

The plurality of insulating layers 221, 222, 223, 224, and 225 may be disposed between the plurality of conductive layers 211, 212, 213, and 214 to prevent short circuit of the adjacent conductive layers 211, 212, 213, and 214. At least one of the plurality of insulating layers 221, 222, 223, 224, and 225 may be provided as a thermosetting resin such as an epoxy resin, a thermoplastic resin such as polyimide, or a resin (e.g., at least one of prepreg, ajinomoto build-up film (ABF), FR-4, or bismaleimide triazine (BT)) impregnated into a core material such as glass fiber (glass cloth, glass fabric) together with an inorganic filler. In FIG. 1, for convenience of explanation, a 5-layered structure in which the plurality of insulating layers 221, 222, 223, 224, and 225 are stacked is illustrated, but the embodiment is not limited thereto, and the number of insulating layers 221, 222, 223, 224, and 225 may be less than 5 or more than 5.

The plurality of conductive layers 211, 212, 213, and 214 may be disposed on the insulating layers 221, 222, 223, 224, and 225 so as to be alternately disposed with the plurality of insulating layers 221, 222, 223, 224, and 225. At least one of the plurality of conductive layers 211, 212, 213, and 214 may include copper (Cu), aluminum (Al), silver (Ag), tin (Sn), gold (Au), nickel (Ni), lead (Pb), titanium (Ti), or an alloy thereof. In the plurality of conductive layers 211, 212, 213, and 214, the plurality of conductive layers 211, 212, 213, and 214 disposed on different planes may be electrically connected through a conductive via 240 disposed in a via hole 242 passing through at least one insulating layer 221, 222, 223, 224, or 225. For example, the plurality of vertically adjacent conductive layers 211, 212, 213, and 214 may be electrically connected through the conductive via 240 disposed in the via hole 242. The conductive via 240 may be provided so that each via hole 242 is completely filled with a metal material or may be disposed along a wall of the via hole 242 except for a center of the via hole 242.

A metal material may be used as a material for the conductive vias 240, and examples of the metal material may include copper (Cu), aluminum (Al), silver (Ag), tin (Sn), gold (Au), nickel (Ni), lead (Pb), titanium (Ti), or an alloy thereof. The conductive via 240 may be made of the same or different material as at least one of the plurality of conductive layers 211, 212, 213, and 214.

A plurality of conductive pads 220 may be disposed on the first outer surface 201 included in the circuit board 200. The conductive pad 220 may be electrically connected through the connection terminals 120 of the semiconductor package 110 connected to the circuit board 200.

At least one opening 230 may be defined adjacent to at least a portion of an edge of the semiconductor package 110. At least one opening 230 may be defined along at least one of the plurality of sides of the semiconductor package 110. At least one opening 230 may be disposed adjacent to at least one connection terminal 120 disposed at the outermost side of the plurality of connection terminals 120. At least one opening 230 may be disposed adjacent to at least one conductive pad 220 disposed at the outermost side of the plurality of conductive pads 220 that are in contact with the semiconductor package 110.

A depth of at least one opening 230 may be deeper than that of at least one of the plurality of via holes 242. At least one opening 230 may be defined in the shape of a groove or hole. The hole-shaped opening 230 may be defined to pass through the first outer surface 201 and the second outer surface 202 of the circuit board 200. The hole-shaped opening 230 may be defined to pass through each of the plurality of insulating layers 221, 222, 223, 224, and 225 included in the circuit board 200. The groove-shaped opening 230 may be defined to pass through at least a portion of at least one of the plurality of insulating layers 221, 222, 223, 224, and 225 included in the circuit board 200.

At least one opening 230 may be provided in plurality. Each of the plurality of openings 230 may be disposed to be spaced apart from the adjacent openings 230. The plurality of openings 230 may be disposed to be spaced apart from adjacent opening 230 in a direction parallel to the edge of the semiconductor package 110.

At least one opening 230 may be provided as one opening. The one opening 230 may be provided in an oval shape with a width and length, which are different from each other. The length of the one opening 230 may be longer than the width. The length of the one opening 230 may be provided parallel to the edge of the semiconductor package 110 and may be longer than the width of the opening 230.

The filling member 300 may be filled into each of the plurality of openings 230. The filling member 300 may be partially or completely filled into a space within the opening 230. The filling member 300 may be in contact with a side surface of each of the plurality of insulating layers 221, 222, 223, 224, and 225 exposed by the opening 230. The filling member 300 may be provided by being filled into the space within the opening 230 with an insulating material (or resin) in a paste state or ink state and then cured. For example, the filling member 300 may be made of the same material as at least one of the plurality of insulating layers 221, 222, 223, 224, and 225. The filling member 300 may absorb or attenuate vibration transmitted through the circuit board 200 due to an externally applied impact. Even though the number of connection terminals 120 that are soldered to the conductive pads 220 is large, a size of each of the connection terminals 120 is small, and a strain rate of each of the connection terminals 120 due to vibration is different, the filling member 300 may absorb and attenuate the vibration. Thus, the present invention may block the vibration from being transmitted to the connection terminals 120 and the semiconductor package 110 to improve vibration durability of the connection terminals 120 and the semiconductor package 110.

The fact that the opening 230 is defined adjacent to at least a portion of the edge of the semiconductor package 110 may mean that the opening 230 is defined close to the semiconductor package 110 so that the presence of the opening 230 effectively reduces the vibration transmitted from the outside to the semiconductor package 110. Specifically, as the opening 230 moves away from the semiconductor package 110, the opening 230 may be defined in a range in which the amount of newly generated vibration on a region between the opening 230 and the semiconductor package 110 is less than the amount by which the opening 230 attenuates the vibration transmitted from the outside to the semiconductor package 110.

The filling member 300 may have a thermal expansion coefficient corresponding to that of at least one of the plurality of insulating layers 221, 222, 223, 224, and 225. The thermal expansion coefficient of the filling member 300 may be the same as or similar to the thermal expansion coefficient of at least one of the plurality of insulating layers 221, 222, 223, 224, and 225. There may be little difference in thermal expansion coefficient between the filling member 300 and the insulating layers 221, 222, 223, 224, and 225. When the circuit board 200 is expanded or contracted due to a temperature change, an expansion rate of the filling member 300 and an expansion rate of each of the insulating layers 221, 222, 223, 224, and 225 may correspond to each other. Stress between the filling member 300 and the insulating layers 221, 222, 223, 224, and 225 may be minimized. Thus, it is possible to prevent cracks from occurring in at least one of the insulating layers 221, 222, 223, 224, and 225 and the filling member 300 due to the temperature change.

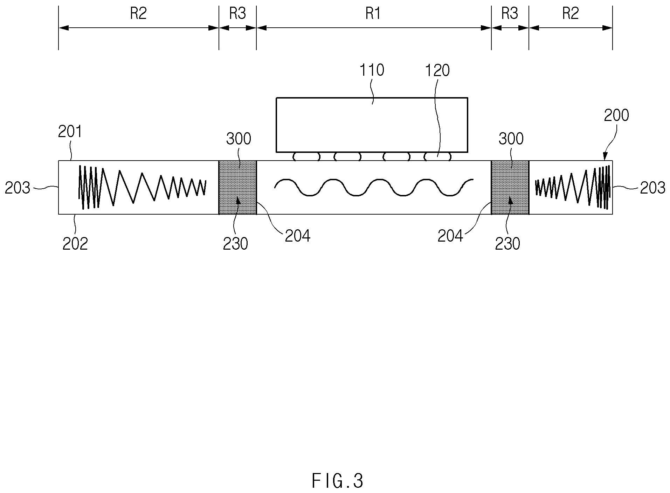

FIG. 3 is a cross-sectional view for explaining a vibration attenuation process of a circuit board assembly according to an embodiment of the present invention.

Referring to FIG. 3, the circuit board 200 according to an embodiment of the present invention may include a first region R1, a second region R2, and a third region R3. At least a portion of the third region R3 may be disposed outside the first region R1, and at least a portion of the second region R2 may be disposed outside the third region R3.

At least one semiconductor package 110 and connection terminals 120 may be disposed on at least a portion of the first region R1. At least a portion of the first region R1 may overlap the semiconductor package 110 and the connection terminals 120. The first region R1 may include a plurality of layer structures. For example, the first region R1 may include a plurality of insulating layers (e.g., insulating layers 221, 222, 223, 224, and 225 in FIG. 2) and a plurality of conductive layers (e.g., conductive layers 211, 212, 213, and 214 in FIG. 2). As described above, the first region R1 may be a region in which the connection terminal 120 is disposed, and the plurality of insulating layers and the plurality of conductive layers are disposed.

The second region R2 may be a region disposed between an outer surface 203 of the circuit board 200 and the filling member 300. Since at least one semiconductor package 110 is not mounted on the second region R2, the second region R2 may not overlap at least one semiconductor package 110 and the connection terminal 120. The second region R2 may include a plurality of layer structures. For example, the second region R2 may include a plurality of insulating layers (e.g., insulating layers 221, 222, 223, 224, and 225 in FIG. 2) and a plurality of conductive layers (e.g., conductive layers 211, 212, 213, and 214 in FIG. 2). As described above, the second region R2 may be a region in which the filling member 300 and the connection terminal 120 are not disposed, and the plurality of insulating layers and the plurality of conductive layers are disposed.

The third region R3 may be disposed between the first region R1 and the second region R2. At least one opening 230 passing through the first outer surface 201 and the second outer surface 202 of the circuit board 200 may be defined in the third region R3. A filling member 300 may be provided within the opening 230. The filling member 300 may be in contact with an inner surface 204 of the circuit board 200 provided by defining the opening 230. As described above, the third region R3 is a region, in which the filling member 300 is disposed, and may be a region in which the connection terminal 120, the plurality of insulating layers, and the plurality of conductive layers are not disposed.

The opening 230 may be defined further outside the connection terminal 120. More specifically, the opening 230 may be disposed outside the outermost connection terminal 120, and the filling member 300 filled in the opening 230 may be disposed further outside than the outermost connection terminal 120 of the plurality of connection terminals 120. That is, one surface of the filling member 300 may be disposed further outside than one surface of the outermost connection terminal 120 of the plurality of connection terminals 120. When external vibration enters the circuit board, the vibration may be transmitted to the first region R1 through the second region R2, and thus, the third region R3 may be disposed between the second region R2 and the first region R1 to allow the vibration passing through the second region R2 to pass through the third region R3 and also reduce an amplitude and energy of the vibration transmitted to the first region R1. For this, the opening 230 defined in the third region R3 may be disposed further outside than the outermost connection terminal 120 of the connection terminals 120 disposed in the first region R1, and the filling member 300 may be filled into the opening 230 to prevent the connection terminal 120 disposed further inside than the openings 230 from being damaged due to the vibration, thereby improving the vibration durability. The filling member 300 may be disposed in a vibration transmission path from the second region R2 to the first region R1 of the circuit board 200. The filling member 300 may be disposed in the vibration transmission path from the outer surface 203 of the circuit board 200 to the inside of the circuit board 200. Since the filling member 300 has a buffering function, the vibration directed to the inner surface 204 of the circuit board 200 may be substantially absorbed and eliminated by the filling member 300 while passing through the filling member 300. As described above, the vibration transmitted from the outside through the inside of the circuit board 200 may be attenuated or absorbed in the filling member 300, and thus, the transmission of the vibration from the second region R2 to the first region R1 of the circuit board 200 may be reduced or blocked. Thus, since the vibration transmitted to the connection terminal 120 and the semiconductor package 110 disposed in the first region R1 is reduced or blocked, the present invention may improve the durability against the vibration.

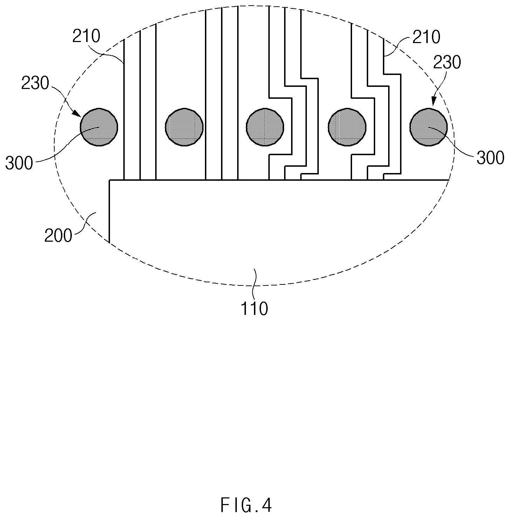

FIG. 4 is a view illustrating a plurality of signal lines disposed on the circuit board according to an embodiment of the present invention.

Referring to FIG. 4, a plurality of signal lines 210 may be disposed on the circuit board 200. Each of the plurality of signal lines 210 may be provided as at least one of a plurality of conductive layers (e.g., conductive layers 211, 212, 213, and 214 in FIG. 2) included in the circuit board 200. The signal lines 210 may perform various functions depending on the design. The signal lines 210 may be electrically connected to the semiconductor package 110 to transmit at least one of an input signal and an output signal of the semiconductor package 110. For example, the signal lines 210 may transmit a ground signal, a power signal, and a control signal.

At least one of the plurality of signal lines 210 may pass between the openings 230 arranged in a row. At least one of the plurality of signal lines 210 may be disposed to bypass at least one of the openings 230. Thus, when defining the opening 230 passing through the plurality of insulating layers 221, 222, 223, 224, and 225, the signal lines 210 disposed around the opening 230 may be prevented from being damaged.

### Circuit board assembly according to second embodiment

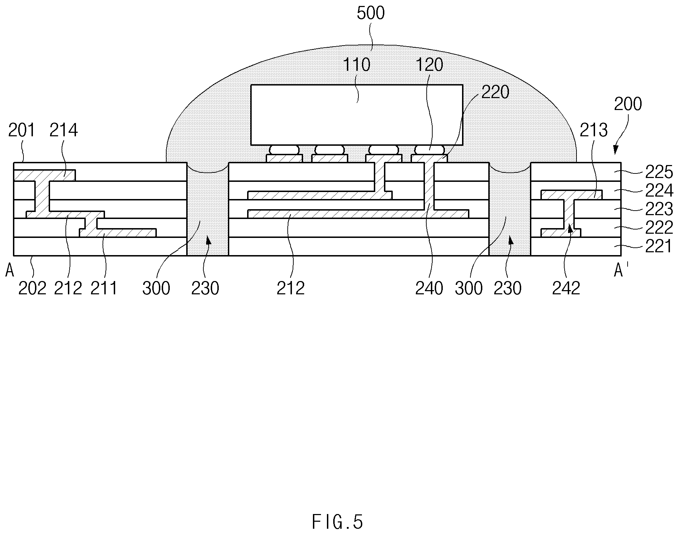

FIGS. 5 to 6 are cross-sectional views illustrating a circuit board assembly according to a second embodiment of the present invention. Hereinafter, a detailed description of the same configuration as that of the circuit board assembly according to the first embodiment of the present invention will be omitted.

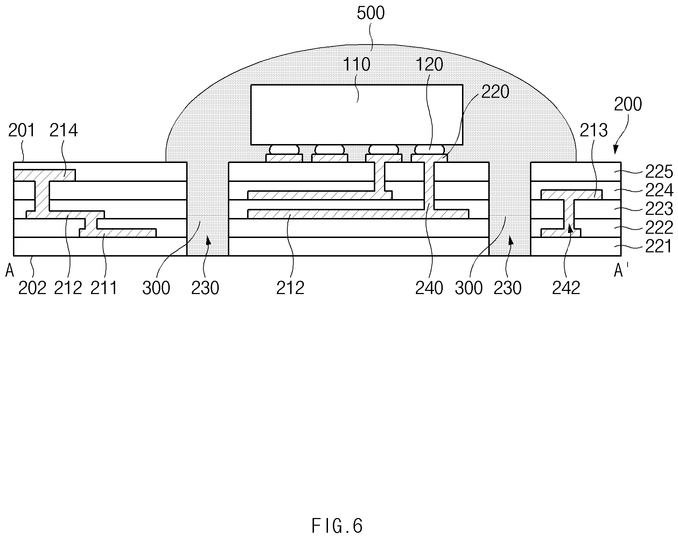

Referring to FIGS. 5 and 6, a circuit board assembly 100 according to the second embodiment of the present invention may include a circuit board 200, a semiconductor package 110, and an encapsulation member 500.

The circuit board 200 may include a plurality of insulating layers 221, 222, 223, 224, and 225, a plurality of conductive layers 211, 212, 213, and 214, at least one conductive pad 220, at least one opening 230, and a filling member 300.

At least one opening 230 may be defined to pass through the first outer surface 201 and the second outer surface 202 of the circuit board 200. As an example, at least one opening 230 may be defined to pass through each of the plurality of insulating layers 221, 222, 223, 224, and 225 included in the circuit board 200.

The filling member 300 may be filled into each of the plurality of openings 230. The filling member 300 may be partially or completely filled into a space within the opening 230. For example, the filling member 300 may be made of the same material as at least one of the plurality of insulating layers 221, 222, 223, 224, and 225. The filling member 300 may absorb or attenuate vibration transmitted through the circuit board 200 due to an externally applied impact. Thus, the present invention may block vibration from being transmitted to connection terminals 120 and the semiconductor package 110.

The filling member 300 may have a thermal expansion coefficient corresponding to that of at least one of the plurality of insulating layers 221, 222, 223, 224, and 225. The thermal expansion coefficient of the filling member 300 may be the same as or similar to the thermal expansion coefficient of at least one of the plurality of insulating layers 221, 222, 223, 224, and 225. Thus, it is possible to prevent cracks from occurring in at least one of the insulating layers 221, 222, 223, 224, and 225 and the filling member 300 due to the temperature change.

The encapsulation member 500 may protect the electrical connection between the circuit board 200 and the semiconductor package 110. The encapsulation member 500 may be provided to cover a portion of the circuit board 200 and the semiconductor package 110. The encapsulation member 500 may be disposed between the connection terminals 120 and between the conductive pads 220.

According to an embodiment, the encapsulation member 500 may be provided to be in contact with the filling member 300 as illustrated in FIG. 5. The encapsulation member 500 may be provided to be in interfacial contact with one surface of the filling member 300, as illustrated in FIG. 5. The encapsulation member 500 may be disposed within a portion of the opening 230 and may be in contact with the filling member 300 within the opening 230. Hereinafter, a method for manufacturing the encapsulation member 500 and the filling member 300 illustrated in FIG. 5 will be described as follows. The filling member 300 may be formed by defining the opening 230 in the circuit board 200 and then printing a first insulating resin using a metal mask. Here, the first insulating resin may be partially filled in the opening 230 to form the filling member 300. Then, after the semiconductor package 110 is mounted, the encapsulation member 500 may be formed by printing the second insulating resin on a portion of the circuit board 200 and the semiconductor package 110. The second insulating resin may be made of the same or different material from the first insulating resin. A portion of the encapsulation member 500 may be filled in the opening 230 so that the encapsulation member 500 is in contact with the filling member 300 within the opening 230.

According to another embodiment, the encapsulation member 500 may be formed to be integrated with the filling member 300 as illustrated in FIG. 6. The encapsulation member 500 may be integrated with the filling member 300 without an interface. Hereinafter, a method for manufacturing the encapsulation member 500 and the filling member 300 illustrated in FIG. 6 will be described as follows. The encapsulation member 500 may be formed by forming an opening 230 in the circuit board 200 and then printing an insulating resin, which is a material of the encapsulation member 500, using a metal mask. Here, a portion of the insulating resin may be filled into the opening 230 to form the filling member 300. A portion of the insulating resin may be squeezed into the opening 230 so that the filling member 300 is easily filled into the opening 230. A remaining portion of the insulating resin may be formed on a portion of the circuit board 200 and the semiconductor package 110 to form the encapsulation member 500. The encapsulation member 500 may be formed of the same material as the filling member 300 and may be integrated with the filling member 300.

The circuit board 200 described above may be mounted on a plurality of semiconductor packages 110 and mounted on a certain electronic device. For example, the circuit board 200 may be mounted on the battery module including a chargeable and dischargeable secondary battery. The battery module may include a battery management system (BMS) that is a safety system to protect the battery cells from overdischarge, overcharge, and overcurrent. The BMS may be made of the semiconductor package 110 and may be mounted on the circuit board 200. The battery module including the BMS mounted on the circuit board 200 may be applied to various devices. It may be applied to transportation means such as electric bicycles, electric vehicles, hybrids, etc., but is not limited thereto and may be applied to various devices capable of using the battery module.

While the embodiments of the present invention have been described with reference to the specific embodiments, it will be apparent to those skilled in the art that various changes and modifications may be made without departing from the spirit and scope of the invention as defined in the following claims.

### [Description of the Symbols]

100: Circuit board assembly
110: Semiconductor package
120: Connection terminal
200: Circuit board
211,212,213,214: Conductive layer
220: Conductive pad
221,222,223,224,225: Insulating layer
230: Opening
240: Conductive via
242: Via hole
300: filling member
500: Encapsulation member

## Claims

1. A circuit board assembly comprising:
a circuit board comprising a first outer surface and a second outer surface, which face each other; and
a semiconductor package disposed on the first outer surface of the circuit board,
wherein the circuit board comprises:
at least one opening disposed adjacent to at least a portion of an edge of the semiconductor package and provided in the form of a groove or hole; and
a filling member filled into the at least one opening.

2. The circuit board assembly of claim 1, wherein the at least one opening is provided in the form of a hole passing through the first outer surface and the second outer surface.

3. The circuit board assembly of claim 1, further comprising at least one or more connection terminals between the semiconductor package and the circuit bard,
wherein the opening is disposed further outside than the connection terminal.

4. The circuit board assembly of claim 3, wherein the connection terminal is provided in plurality, and
one surface of the filling member is disposed further outside than one surface of the connection terminal disposed at the outermost side of the plurality of connection terminals.

5. The circuit board assembly of claim 1, wherein the at least one opening is configured to pass through at least a portion of at least one of a plurality of insulating layers provided in the circuit board.

6. The circuit board assembly of claim 5, wherein a thermal expansion coefficient of the filling member is the same as a thermal expansion coefficient of at least one of the plurality of insulating layers.

7. The circuit board assembly of claim 1, wherein the filling member is made of an insulating resin.

8. The circuit board assembly of claim 1, further comprising:
a plurality of connection terminals configured to electrically connect the semiconductor package to the circuit board, and each of which is provided in the form of a ball;
a plurality of conductive pads connected to the plurality of connection terminals,
wherein the opening is disposed adjacent to at least one connection terminal disposed at the outermost side of the plurality of connection terminals.

9. The circuit board assembly of claim 1, further comprising a signal line provided as at least one of a plurality of conductive layers provided in the circuit board,
wherein the signal line is disposed between the openings or disposed to bypass the openings.

10. The circuit board assembly of claim 5, further comprising:
a plurality of conductive layers disposed between the plurality of insulating layers;
a via hole passing through at least one of the plurality of insulating layers; and
a conductive via provided in the via hole to connect the adjacent conductive layers to each other,
wherein a depth of the opening is deeper than a depth of the via hole.

11. The circuit board assembly of claim 1, further comprising an encapsulation member configured to cover a portion of the circuit board and the semiconductor package and being in contact with the filling member.

12. The circuit board assembly of claim 11, wherein the encapsulation member is in contact with the filling member within the opening.

13. The circuit board assembly of claim 1, further comprising an encapsulation member configured to cover a portion of the circuit board and the semiconductor package and made of the same material as the filling member.

14. The circuit board assembly of claim 13, wherein the encapsulation member is integrated with the filling member.

15. A circuit board comprising a first outer surface that is a surface, on which a semiconductor package is disposed, and a second outer surface facing the first outer surface, the circuit board comprising:
at least one opening disposed adjacent to at least a portion of an edge of the semiconductor package and provided in the form of a groove or hole; and
a filling member filled into the at least one opening.

16. The circuit board of claim 15, wherein the at least one opening is provided in the form of a hole passing through the first outer surface and the second outer surface.

17. The circuit board of claim 15, wherein the at least one opening is configured to pass through at least a portion of at least one of a plurality of insulating layers provided in the circuit board.

18. The circuit board of claim 17, wherein a thermal expansion coefficient of the filling member is made of an insulating resin having the same as a thermal expansion coefficient of at least one of the plurality of insulating layers.

19. The circuit board of claim 15, further comprising at least one or more connection terminals between the semiconductor package and the circuit bard,
wherein the opening is disposed further outside than the connection terminal.

20. The circuit board of claim 19, wherein the connection terminal is provided in plurality, and
one surface of the filling member is disposed further outside than one surface of the connection terminal disposed at the outermost side of the plurality of connection terminals.

21. A battery device comprising:
at least one battery pack each of which comprises a plurality of battery cells;
a battery management system (BMS) configured to manage the plurality of battery cells and provided as a semiconductor package; and
a circuit board of any one of claims 15 to 20, on which the battery management system is mounted.
